# EUROPEAN PATENT APPLICATION

(11) **EP 2 424 341 A1**
(43) Date of publication of application: **29.02.2012**
(21) Application number: 11176061.7
(22) Date of filing: 29.07.2011
(51) Int. Cl.: H05K 7/14

(54) **Printed circuit board housing with tapered locking rails**

(30) Priority: 27.08.2010 US 870397
(71) Applicant: Hamilton Sundstrand Corporation, Windsor Locks, CT 06096-1010 (US)
(72) Inventor: Duffy, Jason C., Granby, CT Connecticut 06060 (US); Desantis, Charles V., Somers, CT Connecticut 06071 (US)
(74) Representative: Tomlinson, Kerry John

(57) **Abstract**

An assembly includes a housing (14), a first locking rail (26A), and a second locking rail (26D). The housing has first and second sidewalls (18,20). First and second guiderails (38,40) on the first sidewall (18). Third and fourth guiderails on the second sidewall (20). The first locking rail is positioned between the first guiderail and the second guiderail. The first locking rail has a first surface (44B) nearest the first guiderail and a second surface (48B) nearest the second guiderail. The first surface is inclined with respect to the second surface. The second locking rail is positioned between the third guiderail and the fourth guiderail. The second locking rail has a third surface nearest the third guiderail and a fourth surface nearest the fourth guiderail. The third surface is inclined with respect to the fourth surface.

## Description

### BACKGROUND

The present invention relates to a housing for a printed circuit board (PCB), and in particular, to mounting a PCB to its housing. In certain applications, one or more printed circuit boards are attached between two walls of a housing. Each wall typically has a channel into which the PCB is slid and clamped in place by a rather complicated wedge lock system. A conventional wedge lock system includes several trapezoidal wedges aligned end-to-end and connected to one another via a bolt extending through holes in each wedge. The bolt applies a longitudinal compressive force on the trapezoidal wedges forcing each adjacent trapezoidal wedge laterally in opposite directions. When such a wedge lock system is placed in the channels with the PCB, tightening the bolt provides a compressive force against the PCB and the channel, thus holding the PCB in place. Housings that utilize these conventional wedge lock systems can be relatively complicated, heavy, and expensive.

### SUMMARY

According to one embodiment of the present invention, an assembly includes a housing, a first locking rail, and a second locking rail. The housing has first and second sidewalls. First and second guiderails extend from the first sidewall toward the second sidewall. Third and fourth guiderails extend from the second sidewall toward the first sidewall. The first locking rail is positioned between the first guiderail and the second guiderail. The first locking rail has a first surface nearest the first guiderail and a second surface nearest the second guiderail. The first surface is inclined with respect to the second surface. The second locking rail is positioned between the third guiderail and the fourth guiderail. The second locking rail has a third surface nearest the third guiderail and a fourth surface nearest the fourth guiderail. The third surface is inclined with respect to the fourth surface.

Another embodiment of the present invention is a method for mounting a printed circuit board to a housing. The method includes positioning a printed circuit board (PCB) in a housing with a first edge portion of the PCB within a first mounting channel on a first sidewall of the housing and a second edge portion of the PCB within a second mounting channel on a second sidewall of the housing, positioning a first tapered locking rail in the first mounting channel and a second tapered locking rail in the second mounting channel, attaching the first tapered locking rail to the first sidewall with a first connector and the second tapered locking rail to the second sidewall with a second connector, and tightening the first and second connectors so as to clamp the PCB between the first tapered locking rail and the first mounting channel and between the second tapered locking rail and the second mounting channel.

### BRIEF DESCRIPTION OF THE DRAWINGS

FIG. 1 is a schematic view of printed circuit boards (PCBs) connected to a housing with tapered locking rails.

FIG. 2 is an enlarged view, taken from FIG. 1, of a connecting mechanism for connecting a PCB to the housing.

FIG. 3 is a schematic perspective view of the housing of FIG. 1.

FIG. 4 is a schematic perspective view of a tapered locking rail of FIG. 1.

### DETAILED DESCRIPTION

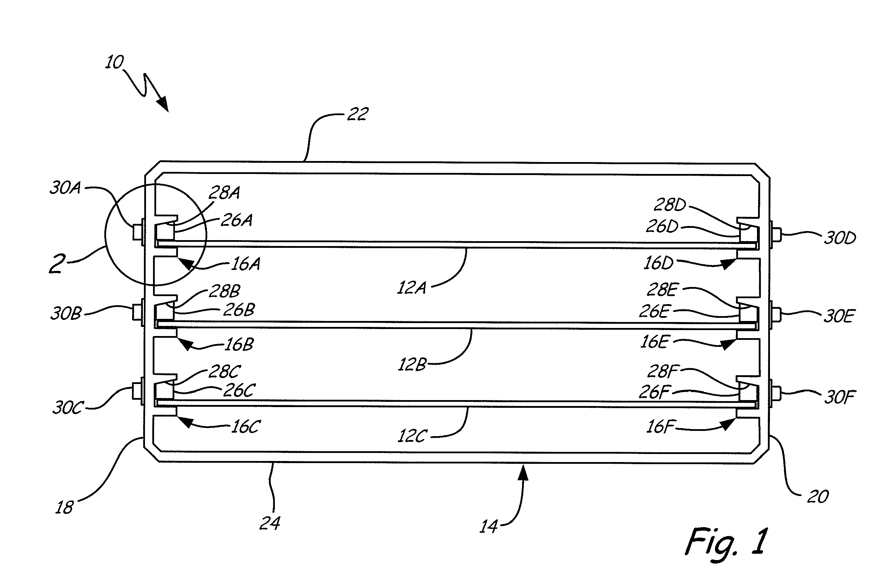

FIG. 1 is a schematic view of assembly 10 including printed circuit boards (PCBs) 12A-12C connected to housing 14 via connecting mechanisms 16A-16F. PCBs 12A-12C can be virtually any kind of printed circuit board, such as polyimide boards used as engine controllers and diagnostic units in an aircraft electronics rack. PCBs 12A-12C can produce a relatively large amount of heat and benefit from that heat being conducted away.

Housing 14 has sidewalls 18, 20, 22, and 24. Sidewall 18 is opposite and substantially parallel to sidewall 20. Sidewall 22 is opposite and substantially parallel to sidewall 24. Sidewall 22 and sidewall 24 each connect sidewall 18 to sidewall 20 so as to form a shape substantially that of a rectangular tube. In one embodiment, housing 14 can be integrally formed and made by extrusion of aluminum. In other embodiments, housing 14 can be cast or machined and can be made of another suitable heat-conducting material.

Connecting mechanisms 16A-16F include locking rails 26A-26F positioned in channels 28A-28F. Locking rails 26A-26F are attached to sidewalls 18 and 20 of housing 14 by connectors 30A-30F, respectively. Locking rails 26A-26F can be aluminum or other suitable heat-conducting material and can be extruded, cast, or machined. Connecting mechanisms 16A-16F can hold PCBs 12A-12C firmly in place and allow heat produced by PCBs 12A-12C to be conducted to housing 14. Thus, housing 14 can act as a heat sink.

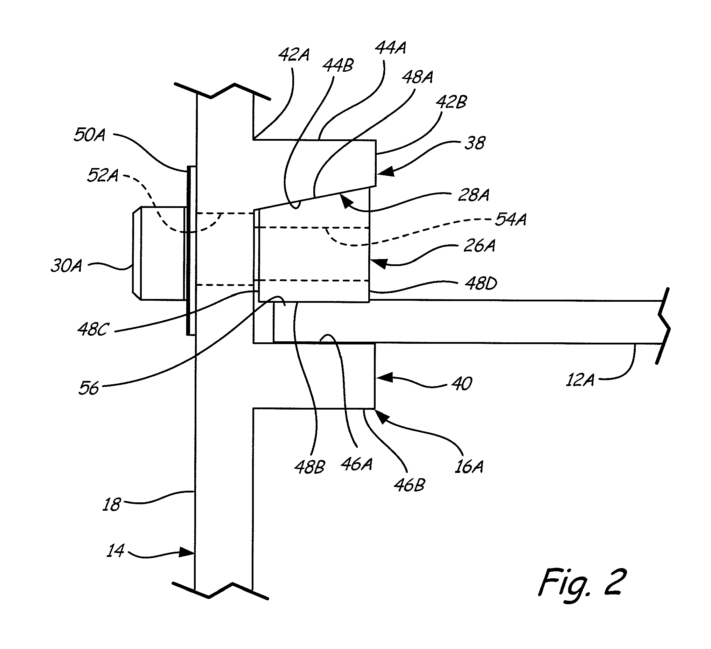

FIG. 2 is an enlarged view, taken from FIG. 1, of connecting mechanism 16A connecting PCB 12A to housing 14. Though FIG. 2 shows only connecting mechanism 16A, the following description is equally applicably to connecting mechanisms 16B-16F (shown in FIG. 1). In the illustrated embodiment, connecting mechanisms 16B and 16C are substantially identical to connecting mechanism 16A, and connecting mechanisms 16D-16F are substantially identical mirror images of connecting mechanism 16A.

Channel 28A is defined by guiderails 38 and 40, which extend, and protrude, from sidewall 18 toward sidewall 20 (shown in FIG. 1). Guiderails 38 and 40 can be integrally formed with sidewall 18. In the illustrated embodiment, guiderail 38 tapers from its base 42A to its distal edge 42B. Guiderail 38 has surface 44A substantially perpendicular to sidewall 18 and has surface 44B not perpendicular with respect to sidewall 18. Guiderail 40 has surfaces 46A and 46B, both substantially perpendicular to sidewall 18.

Locking rail 26A is positioned between guiderails 38 and 40. Locking rail 26A has surface 48A facing and engaging guiderail 38, surface 48B facing guiderail 40, surface 48C facing sidewall 18, and surface 48D facing sidewall 20. Surface 48B is substantially parallel to surface 44A, surface 46A, surface 46B, and PCB 12A, which are all substantially perpendicular to sidewall 18. Surface 48C is shorter than surface 48D such that locking rail 26A tapers from surface 48D to surface 48C. Surfaces 48A and 44B are inclined mating surfaces and are substantially parallel so as to facilitate sliding between locking rail 26A and guiderail 38. Surface 48A can be inclined with respect to surface 48B by an angle of between about 5 degrees to 30 degrees. Surface 44B can be inclined with respect to surface 44A by an angle of between about 5 degrees to 30 degrees. Thus, surfaces 48A and 44B can both be angled with respect to sidewall 18 by between about 60 degrees to 85 degrees. Surfaces 44B and 48A can be referred to as "beveled" surfaces.

In the illustrated embodiment, connector 30A is a threaded fastener such as a screw or bolt. In alternative embodiments, connector 30A can be another type of connector suitable for attaching locking rail 26A to sidewall 18. Connector 30A extends through washer 50A, through hole 52A in sidewall 18, and into hole 54A in locking rail 26A. Connector 30A can be threadedly engaged with hole 54A such that locking rail 26A is forced laterally toward sidewall 18 as connector 30A is tightened. As locking rail 26A is forced toward sidewall 18, the angled incline of surface 48A and surface 48B forces locking rail 26A toward PCB 12A and guiderail 40. PCB 12A is positioned between surface 48B of locking rail 26A and surface 46A of guiderail 40. Locking rail 26A can, therefore, be tightened both against guiderail 38 of housing 14 and against an edge portion 56 of PCB 12A. Thus, the tapered incline of locking rail 26A causes locking rail 26A to clamp PCB 12A between locking rail 26A and guiderail 40 of mounting channel 28A in response to connector 30A forcing locking rail 26A laterally toward sidewall 18.

In the illustrated embodiment, hole 52A has a larger diameter than that of hole 54A. Hole 52A is large enough to allow connector 30A to slide in a direction from guiderail 38 toward guiderail 40 as connector 30A tightens locking rail 26A.

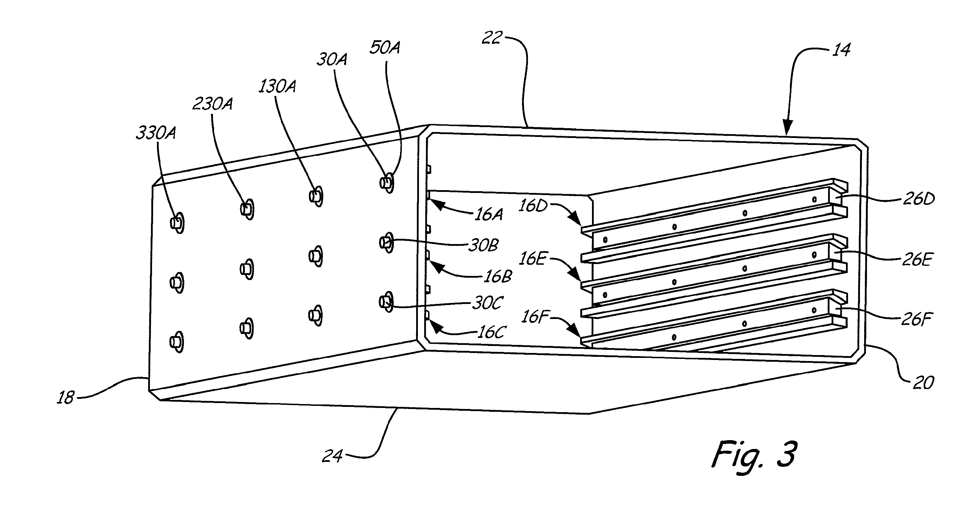

FIG. 3 is a schematic perspective view showing housing 14 and locking rails 26D-26F. In the embodiment illustrated in FIG. 3, connector 30A is grouped with three other connectors 130A, 230A, and 330A for attaching locking rail 26A (shown in FIGS. 1 and 2) to sidewall 18. Connectors 30A, 130A, 230A, and 330A are spaced along a length of sidewall 18 and locking rail 26A. Thus, locking rail 26A can provide substantially even pressure on PCB 12A (shown in FIG. 1) along the length of locking rail 26A to encourage good contact for heat transfer purposes. Similarly, locking rails 26B-26F are also attached to housing 14 with a plurality of connectors.

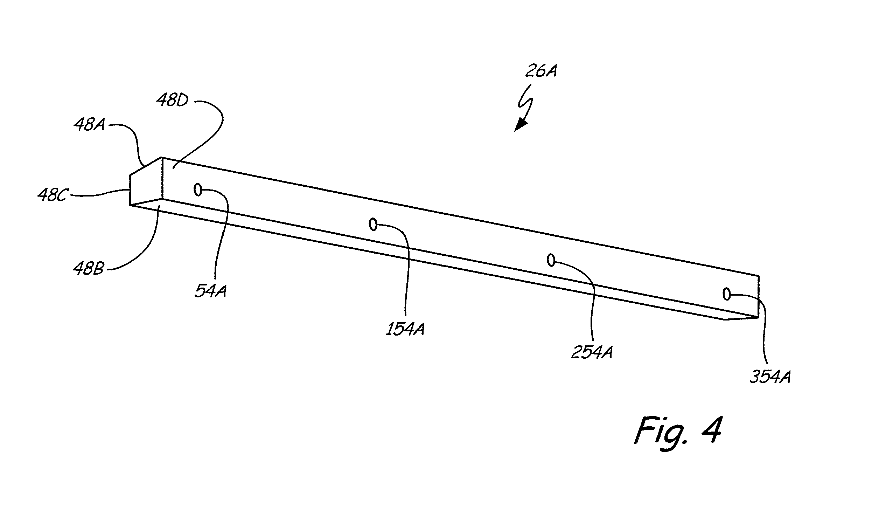

FIG. 4 is a schematic perspective view of locking rail 26A. Though FIG. 4 shows only locking rail 26A, the following description is equally applicably to locking rails 26B-26F (shown in FIG. 1). FIG. 4 shows the shape of locking rail 26A in greater detail, as well as positioning of holes 54A, 154A, 254A, and 354A. In the illustrated embodiment, locking rail 26A is a hexahedron with surfaces 48C and 48D being parallel and surfaces 48A and 48B being inclined. Locking rail 26A can be integrally formed as a single piece. Holes 54A, 154A, 254A, and 354A can extend from surface 48C to and through surface 48D.

Assembly 10 offers numerous benefits and advantages. For example, the various surfaces being angled as described allows for connecting mechanisms 16A-16F to hold PCBs 12A-12C firmly to housing 14 by forcing locking rails 26A-26F laterally toward one of sidewall 18 or sidewall 20. This allows the respective connectors to be positioned in a way that facilitates ease of assembly. Also, by forming each locking rails 26A-26F integrally and forming housing 14 integrally, assembly 10 can be relatively simple, inexpensive, low weight, and reliable. Assembly 10 can be particularly useful in aerospace applications but may be used in other applications as well.

While the invention has been described with reference to exemplary embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims. For example, not all surfaces need to be perpendicular, parallel, and/or angled precisely as illustrated but may be modified as suitable for a particular application.

## Claims

1. A printed circuit board (PCB) mounting assembly comprising:
a housing (14) having a first sidewall (18) with a first mounting channel (28A) with first and second opposed surfaces (44B,46A) and a second sidewall (20) with a second mounting channel (28D) with first and second opposed surfaces;
first and second locking rails (26A,26D) positioned in the first and second mounting channels, respectively;
a space between the first locking rail and the second wall of the first mounting channel and also between the second locking rail and the second wall of the second mounting channel for positioning a PCB; and
first and second connectors (30A,30D) attaching the first and second locking rails to the first and second sidewalls, respectively, wherein the first locking rail is tapered so as to be arranged to clamp the PCB between the first locking rail and the second wall of the first mounting channel in response to the first connector forcing the first locking rail laterally toward the first sidewall, and wherein the second locking rail is tapered so as to be arranged to clamp the PCB between the second locking rail and the second wall of the second mounting channel in response to the second connector forcing the second locking rail laterally toward the second sidewall.

2. The PCB mounting assembly of claim 1, wherein the first connector (30A) extends through a first hole (52A) in the first sidewall (18) and into a second hole (54A) in the first locking rail (26A), and wherein the second connector (30D) extends through a third hole in the second sidewall (20) and into a fourth hole in the second locking rail.

3. The PCB mounting assembly of claim 2, wherein tightening the first and second connectors (30A,30D) tightens the first and second locking rails (26A,26D) against both the housing (14) and the PCB (12A).

4. The PCB mounting assembly of claim 2 or 3, wherein the first hole (52A) has a larger diameter than that of the second hole (54A) and the third hole has a larger diameter than that of the fourth hole, and wherein the first connector (30A) is preferably threadedly engaged with the second hole (54A) and the second connector (30D) is preferably threadedly engaged with the fourth hole.

5. The PCB mounting assembly of any preceding claim, wherein the first connector (30A) is one of a plurality of screws attaching the first locking rail (26A) to the first sidewall (18), and wherein the second connector (30D) is one of a plurality of screws attaching the second locking rail (26D) to the second sidewall.

6. The PCB mounting assembly of any preceding claim, wherein the first locking rail is integrally formed as a single piece and the second locking rail is integrally formed as a single piece.

7. The PCB mounting assembly of any preceding claim, wherein the housing (14) is made of extruded aluminum, and wherein the first and second locking rails (26A,26D) are preferably made of aluminum.

8. The PCT mounting assembly of any preceding claim, wherein:
the first mounting channel (28A) is formed by first and second guiderails (38,40) which extend from the first sidewall (18) toward the second sidewall (20);
wherein the second mounting channel (28D) is formed by third and fourth guiderails which extend from the second sidewall (20) toward the first sidewall (18);
wherein the first locking rail (26A) has a first surface (48A) nearest the first guiderail (38) and a second surface (48B) nearest the second guiderail (40), and wherein the first surface is inclined with respect to the second surface; and
wherein a second locking rail (26D) is positioned between the third guiderail and the fourth guiderail, wherein the second locking rail has a third surface nearest the third guiderail and a fourth surface nearest the fourth guiderail, and wherein the third surface is inclined with respect to the fourth surface.

9. The assembly of claim 8, wherein a surface of the first guiderail (38), which is the first surface (44b) of the first channel (28A), facing the first surface (48A) of the locking rail (26A) is substantially parallel to the first surface for mating with the first surface, and wherein a surface of the third guiderail, which is the first surface of the second channel (28D), facing the third surface is substantially parallel to the third surface for mating with the third surface.

10. The assembly of claim 9, wherein the first surface (48A) of the first locking rail (26A) is angled with respect to the second surface (48B) of the first locking rail (26A) by between about 5 degrees to 30 degrees, and wherein the third surface of the second locking rail (26D) is angled with respect to the fourth surface of the second locking rail by between about 5 degrees to 30 degrees, and wherein the surface (44B) of the first guiderail (38) facing the first locking rail is (28A) preferably angled with respect to a surface (46A) of the second guiderail (40) facing the first locking rail by between about 5 degrees to 30 degrees, and wherein a surface of the third guiderail facing the second locking rail (28D) is preferably angled with respect to a surface of the fourth guiderail facing the second locking rail by between about 5 degrees to 30 degrees.

11. The assembly of claim 8, 9 or 10, wherein the first guiderail (38) tapers from its base (42A) to its distal edge (42B) and the third guiderail tapers from its base to its distal edge.

12. The assembly of any one of claims 8 to 11, wherein the housing (14) further includes a third sidewall (22) and a fourth sidewall (24), both connecting the first sidewall (18) to the second sidewall (20), and wherein the first sidewall, second sidewall, third sidewall, fourth sidewall, first guiderail, second guiderail, third guiderail, and fourth guiderail are preferably integrally formed.

13. A method for mounting a printed circuit board (12A) to a housing (14), the method comprising:
positioning the printed circuit board (PCB) in the housing with a first edge portion of the PCB within a first mounting channel (28A) on a first sidewall (18) of the housing and a second edge portion of the PCB within a second mounting channel on a second sidewall (20) of the housing;
positioning a first tapered locking rail (26A) in the first mounting channel and a second tapered locking rail (26D) in the second mounting channel;
attaching the first tapered locking rail to the first sidewall with a first connector (30A) and the second tapered locking rail to the second sidewall with a second connector (30B); and
tightening the first and second connectors so as to clamp the PCB between the first tapered locking rail and a wall of the first mounting channel and between the second tapered locking rail and a wall of the second mounting channel.

14. The method of claim 13, wherein tightening the first connector (30A) forces the first tapered locking rail (26A) toward the PCB (12B) and toward the first sidewall (18), and wherein tightening the second connector (30D) forces the second tapered locking rail (26D) toward the PCB and toward the second sidewall (20)
the method preferably further comprising:
inserting the first connector (30A) through a first hole (52A) in the first sidewall (18) and into a second hole (54A) in the first tapered locking rail (26A); and
inserting the second connector (30D) through a third hole in the second sidewall (20) and into a fourth hole in the second tapered locking rail (26D).

15. The assembly of claim 13 or 14, wherein the housing (14) is aluminum and made by extrusion.
